# EUROPÄISCHE PATENTSCHRIFT

(11) **EP 0 853 657 B1**
(45) Veröffentlichungstag und Bekanntmachung des Hinweises auf die Patenterteilung: **26.12.2007**
(21) Anmeldenummer: 97934543.6
(22) Anmeldetag: 25.07.1997
(51) Int. Cl.: C12M 1/00, B01L 1/00

(54) **OBJEKT-LAGERVORRICHTUNG, LAGERSTATION UND KLIMASCHRANK**
STORAGE DEVICE FOR OBJECTS, STORAGE STATION, AND AIR-CONDITIONED CABINET
DISPOSITIF DE STOCKAGE D'OBJETS, STATION DE STOCKAGE ET ARMOIRE DE CLIMATISATION

(30) Priorität: 05.08.1996 DE 29613557 U; 09.05.1997 CH 109797
(43) Veröffentlichungstag der Anmeldung: 22.07.1998
(73) Patentinhaber: Thermo Electron LED GmbH, 63505 Langenselbold (DE); LICONIC AG, 9485 Nendeln (LI)
(72) Erfinder: HELWIG, Günter, D-63457 Hanau (DE); MALIN, Cosmas, FL-9493 Mauren (LI)
(74) Vertreter: Wiedemann, Peter
(86) Internationale Anmeldenummer: PCT/EP1997/004045
(87) Internationale Veröffentlichungsnummer: WO 1998/005753

(56) Entgegenhaltungen:
- EP-A- 0 165 172
- EP-A- 0 281 547
- EP-A- 0 293 782
- WO-A-92/14550
- US-A- 4 250 266
- US-A- 5 541 897

## Beschreibung

Die Erfindung betrifft eine Lagerstation und einen Klimaschrank gemäss Oberbegriff der unabhängigen Ansprüche. Eine Lagerstation dieser Art wird in US 5 541 897 offenbart.

WO 92/14550 beschreibt einen - Inkubator, bei welchem die Zugabe von Testreagenzien automatisch mittels einem in x-y-Richtung beweglichen Pipettenspitzen-Manipulators erfolgt, wobei der Manipulator nicht für den Transport der Objektträger benutzt wird.

EP 293 782 beschreibt einen Inkubator mit einer karussellförmigen Lagervorrichtung für Zellkulturen. Eine Transporteinrichtung für die Zellkulturen ist nicht vorgesehen.

Objekt-Lagervorrichtungen dieser Art werden überall dort verwendet, wo Objekte während einer gewissen Zeit gelagert werden müssen. Die Objekte sind im allgemeinen einzeln oder gruppenweise in Objektträgern aufgenommen, bei welchen es sich zum Beispiel um offene Schalen oder um geschlossene Behälter handeln kann. Die Objektträger sind entfernbar an einer Struktur der Objekt-Lagervorrichtung angeordnet und werden dieser Struktur In den Objektträgern zugeführt bzw. von Ihr entfernt. Die Objekt-Lagervorrichtung umfasst die Objekttträger und die genannte Struktur. Bekannt sind beispielsweise Objekt-Lagervorrichtungen in Form von mehrstökkigen Karussellen, mit kreissektorförmigen Objektträgern. Die Objektträger liegen dabei im allgemeinen auf der Struktur auf und werden durch seitlich verschiebbare Klemmteile festgehalten. Der Nachteil dieser Anordnung ist ihr verhältnismässig aufwendiger Aufbau mit den Klemmteilen und der zu deren Betätigung notwendigen Antriebsvorrichtung.

Es ist Aufgabe der Erfindung, eine alternative Lagerstation für Objekte zu entwickeln, die eine automatische, schnelle und einfache Beschickung der Objektträger in/aus der Lagerstation ermöglicht.

Diese Aufgabe wird erfindungsgemäss durch die Merkmale des kennzeichnenden Teils des Patentanspruchs **1** gelöst; vorteilhafte Weiterbildungen der erfindungsgemässen Objekt-Lagervorrichtung werden durch die Patentansprüche **2** bis **9** definiert.

Wie schon erwähnt, befinden sich die Objekte in der Objekt-Lagervorrichtung in Objektträgern, die an der karussellartigen Struktur der Objekt-Lagervorrichtung angeordnet sind, wobei die Objektträger nur seitlich an der Struktur aufliegen und somit von unten frei zugänglich und nach oben abhebbar sind. Die seitlichen Klemmteile und ihre Antriebe, wie sie bei vorbekannten Objekt-Lagervorrichtungen vorhanden sind, werden bei der neuen Objekt-Lagervorrichtung nicht benötigt, die dadurch wesentlich einfacher im Aufbau ist als die vorbekannten Objekt-Lagervorrichtungen.

Die Objektträger können seitlich geführt sein, wodurch das präzise Zubringen zur Struktur vereinfacht und ihre Lage an der Struktur seitlich gesichert ist.

Für eine besonders rationelle Beschickung der Objekt-Lagervorrichtung werden vorzugsweise Kassetten verwendet, welche jeweils mehrere übereinander angeordnete Objektträger umfassen. Auch diese Kassetten sind von unten frei zugänglich, nach oben abhebbar und ggfs. seitlich, geführt.

Zur Aufnahme der Objektträger kann die Objekt-Lagervorrichtung auch Tablare mit Ausnehmungen besitzen, welche den Zugriff zu den Unterflächen der Objektträger ermöglichen.

Lagerstationen der eingangs genannten Art umfassen eine Objekt-Lagervorrichtung und eine Transporteinrichtung, mittels welcher einzelne Objekte oder Gruppen von Objekten, die im allgemeinen in Objektträgern aufgenommen sind, der Objekt-Lagervorrichtung zugeführt und von ihr entnommen werden. Die Objektträger werden der Lagerstation durch einen Zufuhr-Förderer geliefert und nach ihrer Behandlung mittels eines Abfuhr-Förderers von der Lagerstation wieder weggeführt; dazu kann auch ein kombinierter Zu- und Abfuhr-Förderer dienen, beispielsweise eine Endlosförderer oder ein Roboter.

Die neue Lagerstation weist eine karussell artige Objekt-Lagervorrichtung mit mindestens einer Lagerebene mit mehreren kreissektorförmigen Objekt-Lagerstellen auf. In diesen werden zeitweilig Objekte aufgenommen, die einzeln oder gruppenweise in Objektträgern aufgenommen sind. Im weiteren gehört ein Transportsystem zur Lagerstation, mittels welchem die Objektträger in die Objekt-Lagervorrichtung eingebracht bzw. aus ihr entfernt werden. Erfindungsgemäss besitzt das Transportsystem ein zur Aufnahme der Objektträger vorgesehenes Element, das parallel und senkrecht zur Achse der karussellartiogen Objekt-Lagervorrichtung, mithin also radial zur Objekt-Lagervorrichtung, verschiebbar ist.

Vorzugsweise ist die Transporteinrichtung so ausgebildet, dass das Element, welches zur Aufnahme der Objektträger dient, zwischen zwei Übergabelagen schwenkbar ist, wobei die Schwenkachse parallel zur Achse der Objekt-Lagervorrichtung gerichtet ist. In der ersten Übergabelage wechselt der Objektträger zwischen dem Element und zum Beispiel einem Zu- bzw. Abfuhrförderer. In der zweiten Übergabelage ist das Element auf eine Objekt-Lagerstelle gerichtet.

Eine Lagerstation, die sich als günstig erwiesen hat, weist eine Objekt-Lagervorrichtung gemäss der vorliegenden Erfindung auf.

Vorzugsweise ist dabei das zur Aufnahme der Objektträger bestimmte Element als eine flache Schaufel oder ggfs. als eine Doppelschaufel ausgebildet, die mittels der Transporteinrichtung radial unter die in der Objekt-Lagervorrichtung befindlichen Objektträger geschoben, anschliessend ebenfalls mittels der Transporteinrichtung angehoben und schliesslich aus der Objekt-Lagervorrichtung zurückgezogen wird, so dass die Objektträger auf die Schaufel zu liegen kommen und auf ihr transportiert, beispielsweise verschwenkt werden können, dies alles, wenn sie der Objekt-Lagervorrichtung entnommen und zu einem Abfuhrförderer gebracht werden sollen.

Zur Behandlung von Objekten unter Extremalbedingungen kann die Lagerstation in einem geeigneten Klimaschrank angeordnet sein, der ein Fenster besitzt, durch dessen Fensteröffnung sich die Objektträger entweder mittels der Transporteinrichtung oder mittels der Zu- und Abfuhr-Förderer verschieben lassen.

Zur Behandlung von Objekten müssen diese häufig während einer bestimmten Zeit unter Extremalbedingungen gelagert werden, wozu sie in Klimaschränke gebracht werden. Klimaschränke dienen zum Beispiel zum Bebrüten von Zellkulturen und Mikroorganismen, die nur unter bestimmten Temperaturen und Feuchtigkeitsbedingungen sowie in einer genau definierten Atmosphäre optimal gedeihen. Um grosse Mengen einzelner Objekte bzw. Präparate behandeln zu können, ist es notwendig, solche Klimaschränke automatisch zu be- und zu entladen. Gelegentlich kann es auch notwendig sein, nur einzelne der Präparate in den Klimaschrank zu fördern oder aus ihm zu entnehmen. Wenn möglich soll während des Be- oder Entladens keine Änderung der im Klimaschrank herrschenden Verhältnisse stattfinden.

In der EP-0 293 782 ist ein Klimaschrank mit einer automatischen Zugriffsmöglichkeit beschrieben. Der Klimaschrank enthält eine manuell betätigbare verhältnismässig grosse Türe, innerhalb welcher ein automatisch betätigbares Fenster angeordnet ist. Im Inneren des Klimaschrankes befindet sich eine Objekt-Lagervorrichtung zur Aufnahme einer Vielzahl von Objekten, welche als mehrstöckiges drehbares Karussell ausgebildet ist, mit sektorartigen Lagerstellen für jeweils ein Objekt. Die Türe dient zum Ein- und Ausbauen des Karussells sowie zum Reinigen und Instandhalten des Inneren des Klimaschrankes. Das Fenster bietet die Möglichkeit, einzelne Objekte in den Klimaschrank zu bringen oder sie aus ihm zu entnehmen. Zum Transport einzelner Objekte zwischen dem Äusseren des Klimaschrankes und den Lagerstellen kann ein Roboter verwendet werden. Nachteilig an diesem Klimaschrank ist es, dass das Fenster verhältnismässig gross ist, so dass beim Öffnen des Fensters verhältnismässig grosse Klimaschwankungen im Klimaschrank entstehen. Die dadurch entstehende Klimainstabilität wirkt sich besonders bei häufigen Zugriffen ungünstig auf die Behandlung der im Klimaschrank befindlichen Objekte aus. Konstruktiv ist es ausserdem ungünstig, das Fenster als Bestandteil der Türe auszubilden, da dann bei der Bedienung der Türe auch der Bedienungsmechanismus des Fensters betätigt werden muss. Ausserdem weist durch diese Kombination von Fenster und Türe der Klimaschrank nur eine Öffnung auf einer Seite auf, was beispielsweise bei einer erwünschten raschen Auskühlung sowie bei Reinigungs- und Instandhaltungsarbeiten ungünstig ist.

In der US-5,470,744 ist ein Klimaschrank dargestellt, der ebenfalls eine karussellartige Objekt-Lagervorrichtung mit einer Vielzahl von Lagerstellen für Objekte enthält. Auch dieser Klimaschrank ist mittels eines äusseren Roboters be- und entladbar. Er besitzt hingegen zwei Öffnungen, nämlich eine verhältnismässig grosse, manuell betätigbare Türe sowie eine weitere, der Türe gegenüberliegende Öffnung, welche durch ein flexibles Paneel abgeschirmt ist. Das Paneel weist eine schlitzartige Fensteröffnung auf, die gerade so gross ist, dass ein Objekt durch die Fensteröffnung gebracht werden kann, wenn der Klimaschrank beladen oder entladen wird. Das Paneel ist oben und unten an Rollen befestigt und durch Drehung dieser Rollen auf die letzteren aufwickelbar bzw. von diesen abwickelbar, wobei sich die Fensteröffnung auf- bzw. abwärts verschiebt, bis sie in der Höhe der mit Objekten zu beschickenden Etage der Objekt-Lagervorrichtung angelangt ist. In seiner untersten oder obersten Lage sollte die Fensteröffnung nicht mit der Türe fluchten, damit der Klimaschrank gänzlich verschlossen ist. Mit diesem Paneel erreicht man, dass der Klimaschrank bei der Be- oder Entladung nur durch eine kleine Öffnung, nämlich die Fensteröffnung, mit der Umgebung in Verbindung steht. Nachteilig bei diesem Klimaschrank sind aber die mangelhafte Isolation der gesamten Türöffnung sowie der grosse konstruktive Aufwand für das Paneel und seine Bewegungen, insbesondere auch zu völligen Verschliessen der Fensteröffnung. Ausserdem müssen die Bewegungen des Roboters, welcher die Objekte zu- und abführt, genau auf die jeweilige Höhenlage des Fensters abgestimmt sein.

Zusammenfassend kann festgestellt werden, dass kein Klimaschrank bekannt ist, der die an ihn gestellten Anforderungen gänzlich erfüllt.

Die dritte Aufgabe der Erfindung wird somit darin gesehen, einen verbesserten Klimaschrank der eingangs genannten Art zu schaffen.

Diese dritte Aufgabe wird, ausgehend von einem Klimaschrank gemäss dem Stand der Technik, wie er der erwähnten US-5,470,744 beschrieben ist, durch die Merkmale des kennzeichnenden Teils des Patentanspruchs **10** gelöst. Vorteilhafte Weiterbildungen des erfindungsgemässen Klimaschrankes sind durch die vom Patentanspruch **10** abhängigen Patentansprüche **11** bis **15** definiert.

Vorzugsweise weist der Klimaschrank eine Lagerstation mit der genannten Objekt-lagervorrichtung und mit einer Transporteinrichtung auf, welche dazu bestimmt ist, die Objektträger zwischen den Lagerstellen der Objekt-Lagervorrichtung und der Nähe der Fensteröffnung hin- und her zu transportieren.

Bei einem bevorzugten Klimaschrank weist die zur Aufnahme der zu behandelnden Objekte angeordnete Objekt-Lagervorrichtung einzelne oder alle Merkmale der weiter oben beschriebenen Objekt-Lagervorrichtung gemäss der vorliegenden Erfindung auf.

Ein besonders vorteilhafter Klimaschrank enthält eine Lagerstation mit einer Objekt-Lagervorrichtung und einer Transporteinrichtung, welche einzelne oder alle Merkmale der weiter oben beschriebenen Lagerstation gemäss der vorliegenden Erfindung aufweisen.

Das Fenster des Klimaschrankes ist, wie schon erwähnt, der Grösse der Objekte bzw. der Objektträger angepasst. Darunter soll verstanden werden, dass die Fensteröffnung Abmessungen aufweist, die um ein weniges grösser sind als die Abmessungen der Objektträger einschliesslich der Schaufel bzw. einer Greifvorrichtung der Transporteinrichtung oder einschliesslich einer entsprechenden Vorrichtung des Zu- und Abfuhrförderers.

Es hat sich als günstig erwiesen, den Klimaschrank mit einer vorzugsweise manuell bedienbaren Türe zu versehen, die im allgemeinen der Fensteröffnung gegenüberliegt und höher und breiter ausgebildet ist als die Fensteröffnung. Durch diese Türe bilden einen Durchlass für Objekt-Lagervorrichtungen mit oder ohne Objekten.

Weitere Eigenschaften und Vorteile der Erfindung werden im folgenden anhand von Ausführungsbeispielen und mit Bezug auf die Zeichnung beschrieben. Es zeigt:
- **Fig. 1**: ein erstes Ausführungsbeispiel eines Klima schrankes mit einer darin angeordneten Lagerstation, in Draufsicht;
- **Fig. 2**: ein zweites Ausführungsbeispiel eines Klimaschrankes mit einer darin angeordneten Beahndlungsstation, von der Seite;
- **Fig. 3a**: ein drittes Ausführungsbeispiel eines Klimaschrankes mit einer darin angeordneten Bahandlungsstation; mit zwei nebeneinanderliegenden karussellartigen Objekt-Lagervorrichtungen, in Draufsicht;
- **Fig. 3b**: ein viertes Ausführungsbeispiel eines Klimaschrankes mit einer darin angeordneten Beahndlungsstation; mit zwei konzentrischen karussellartigen Objekt-Lagervorrichtungen, in Draufsicht;
- **Fig. 4a**: die Transporteinrichtung der Lagerstation des in Fig. 1 dargestellten Klimaschrankes in einer ersten Stellung, von der Seite;
- **Fig. 4b**: die in Fig. 4a dargestellte Transporteinrichtung in einer zweiten Stellung, ebenfalls von der Seite;
- **Fig. 5a**: ein erstes Ausführungsbeispiel einer Objekt-Lagervorrichtung, in einem Schaubild;
- **Fig. 5b**: ein zweites Ausführungsbeispiel einer Objekt-Lagervorrichtung, ausschnittweise, in einem Schaubild;
- **Fig. 6a**: eine erste Variante des Entladens des erfindungsgemässen Klimaschrankes, in einem Flussdiagramm;
- **Fig. 6b**: eine erste Variante des Beschickens des erfindungsgemässen Klimaschrankes, in einem Flussdiagramm;
- **Fig. 6c**: eine zweite Variante des Entladens des erfindungsgemässen Klimaschrankes, in einem Flussdiagramm;
- **Fig. 6d**: eine zweite Variante des Beschickens des erfindungsgemässen Klimaschrankes, in einem Flussdiagramm; und
- **Fig. 7**: eine Lagerstation mit einer Objekt-Lagervorrichtung und mit einer Transporteinrichtung, die beide ausserhalb eines Klimaschrank angeordnet sind, jedoch in gleicher Konfiguration auch in einem Klimaschrank angeordnet sein könnten.

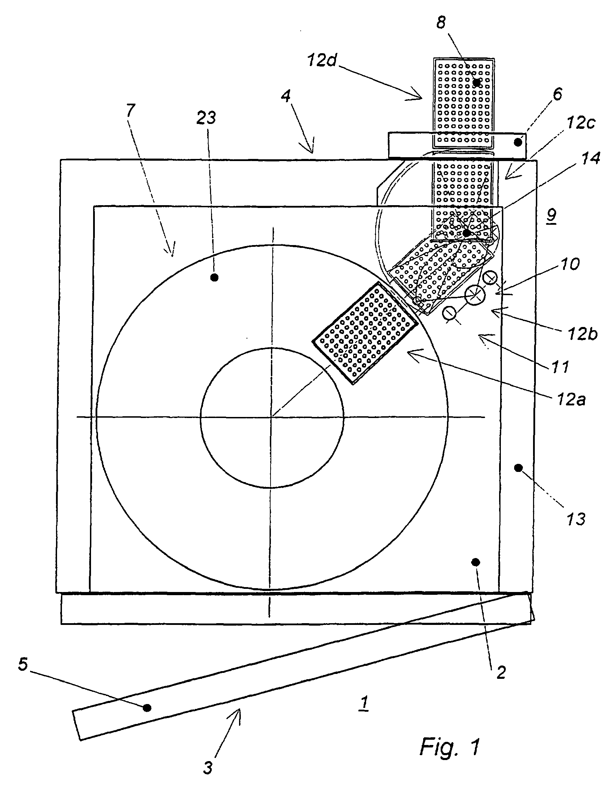

Der in Fig. **1** dargestellte Klimaschrank **1** weist einen Nutzraum **2** auf, zu welchem man sowohl von einer Benutzerseite **3** wie auch von einer Roboterseite **4** aus Zugriff hat. Der Klimaschrank **1** besitzt auf der Benutzerseite **3** eine vorzugsweise manuell bedienbare Türe **5** und auf der Roboterseite **4** eine Fensteröffnung mit einem automatisch bedienbaren Fensterflügel, welche zusammen ein Fenster **6** bilden.

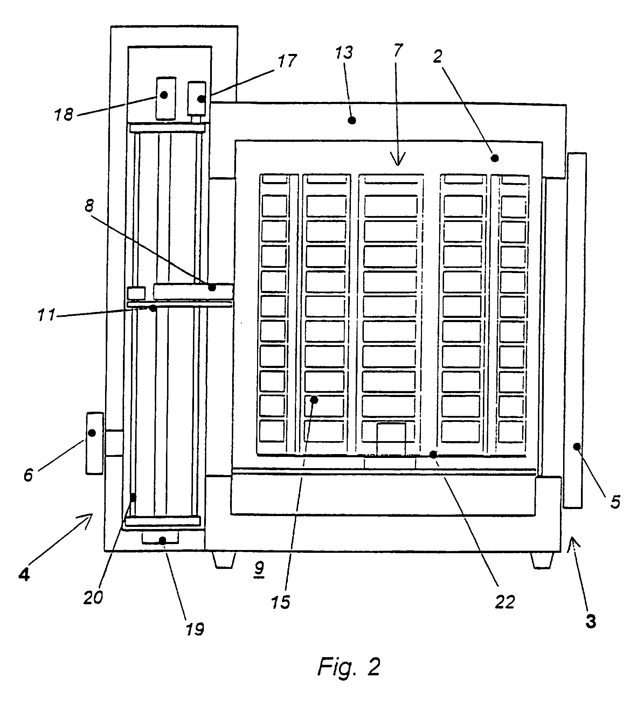

Im Nutzraum **2** des Klimaschrankes **1** befindet sich gemäss den **Fig. 1** und **2** eine Lagerstation mit einer Objekt-Lagervorrichtung **7** und einer Transporteinrichtung **11**. Die zylindrische Objekt-Lagervorrichtung **7** weist Lagerstellen **23** für im Klimaschrank **1** zu behandelnde Objekte bzw. für diese Objekte enthaltende Objektträger **8** auf. Im weiteren Verlauf der Beschreibung werden sowohl Objekte, die keines Objektträgers bedürfen, wie auch Objektträger mit Objekten generell als Objektträger bezeichnet. Die Objekt-Lagervorrichtung **7** ist karussellartig ausgebildet, das heisst, sie besitzt eine Struktur in Form eines Karussells mit mehreren Etagen, wobei in jeder Etage kreissektorartig ausgebildete und radial beschickbare Objekt-Lagerstellen **23** für die Objektträger **8** vorhanden sind. Die Objekt-Lagervorrichtung **7** ist mittels eines nicht dargestellten Antriebs um ihre vertikale Achse drehbar, so dass die jeweils übereinander angeordneten Lagerstellen **23** in eine Position gedreht werden können, in welcher sie mit den Objektträgern **8** beschickt bzw. von den Objektträgern **8** entleert werden können.

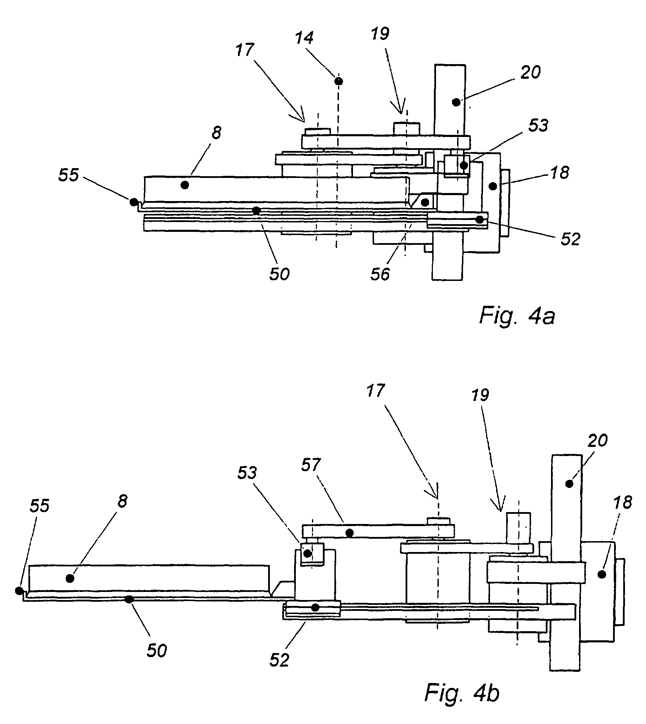

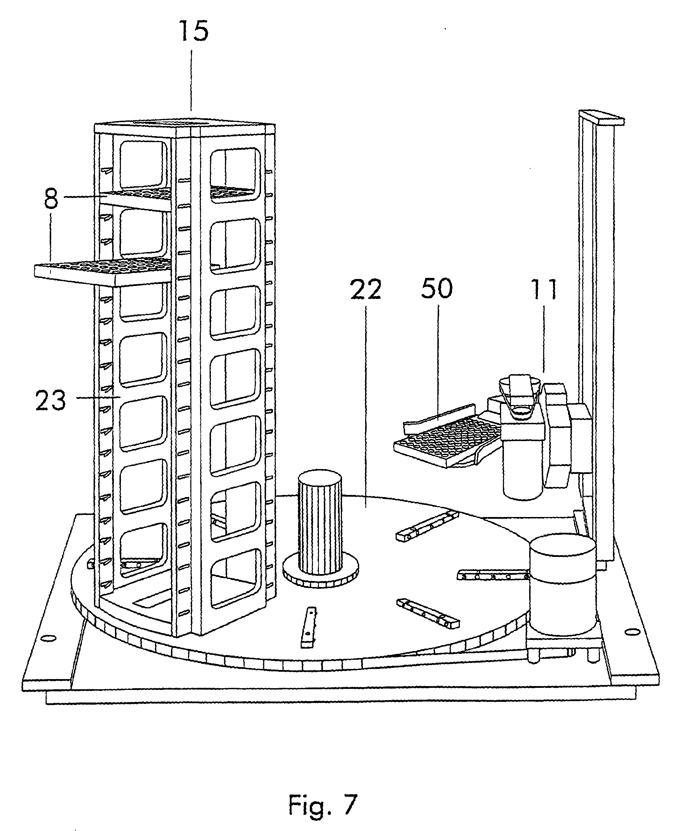

Der Klimaschrank **1** besitzt eine in seinem Inneren angeordnete Transporteinrichtung **11**, mittels welcher jeweils ein Objekt bzw. Objektträger **8** zwischen dem Äusseren des Klimaschrankes **1** und einer Lagerstelle **23** im Inneren des Klimaschrankes **1** hin- und her transportiert werden kann. Die Transporteinrichtung **11** weist einen plattenartigen Träger bzw. eine Schaufel **50** auf, die auch in den **Fig. 4a, 4b** und **7** sichtbar ist, und die für jeweils einen Objektträger **8** bestimmt ist. Diese Schaufel **50** ist in **Fig. 1** in vier Lagen dargestellt, die mit **12a, 12b, 12c** und **12d** bezeichnet sind. Bei **12a** und **12d** befindet sich die Schaufel **50** in Übernahmelagen, wobei sie in der Lage gemäss **12a** den Objektträger **8** an die Objekt-Lagervorrichtung **7** abgibt bzw. von ihr entfernt, und in der Lage gemäss **Fig.12d** das Objekt von einem nicht dargestellten Zu- und Abfuhr-Förderer übernimmt bzw., an diesen abgibt. Bei **12b** und **12c** befindet sich die Schaufel **50** in einer Transportlage, in der sie schwenkbar ist, wobei in der Lage gemäss **12b** die Schaufel **50** mit einer Lagerstelle **23** fluchtet, während er in der Lage gem. **Fig. 12c** mit dem Fenster **6** fluchtet.

**Fig. 2** zeigt einen Klimaschrank **1**, bei welchem die Transporteinrichtung **9, 11** nicht wie beim Klimaschrank gemäss **Fig. 1** in einer Ecke des Nutzraums **2** sondern in einer Erweiterung des Nutzraums **2** angeordnet ist. Die Objekt-Lagervorrichtung **7** umfasst in diesem Ausführungsbeispiel mehrere Kassetten **15**, die auf einer Drehplatte **22** aufliegen. Die Ausbildung der Transporteinrichtung ist aber im Prinzip gleich wie beim Klimaschrank gemäss **Fig. 1**. Die Schaufel **50** lässt sich mittels eines Horizontalantriebs **17** linear zwischen den Lagen **12a, 12b** sowie zwischen den Lagen **12c, 12d** verschieben und mittels eines Drehantriebs **19** um eine Drehachse **14** zwischen den Lagen **12b** und **12c** hin- und herschwenken. Die oben beschriebenen Teile bilden eine Horizontalverschiebeeinrichtung der Transporteinrichtung. Da im vorliegenden Ausführungsbeispiel das Karussell **15** mehrere Etagen aufweist, umfasst die Transporteinrichtung im weiteren eine Vertikalverschiebeeinrichtung bzw. einen Lift **10**, mit welchem die Schaufel **50** mittels eines Vertikalantriebs **18** linear auf- und abwärtsverschoben wird, sowohl, um die erforderliche Etage zu erreichen wie auch um einen Objektträger anzuheben.

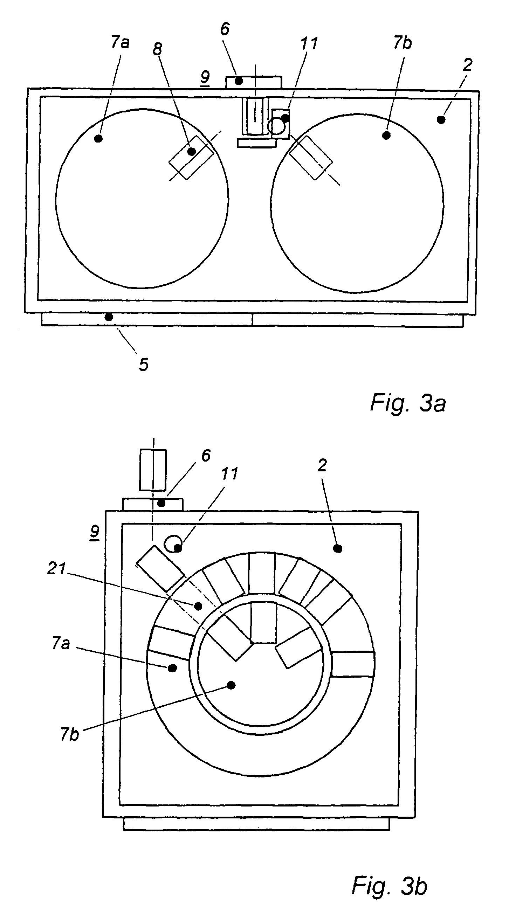

**Fig. 3a** zeigt einen weiteren Klimaschrank mit zwei Objekt-Lagervorrichtungen **7a, 7b** in Form von Karussellen, die nebeneinander mit parallelen Drehachsen angeordnet sind. Bei diesem Klimaschrank dient eine einzige Transporteinrichtung **9, 11** dazu, beide Karusselle **7a, 7b** zu beschicken bzw. zu entleeren. Eine solche Ausbildung ist konstruktiv einfach und verhältnismässig preisgünstig, eignet sich aber nicht, wenn die Objekte im Klimaschrank in kurzen Zeitabschnitten ausgetauscht werden sollen.

Der in **Fig. 3b** dargestellte Klimaschrank ist verhältnismässig platzsparend, da zwei Karusselle **7a, 7b** konzentrisch angeordnet sind, die mit einem Transfersystem **9, 11** bedienbar sind. Allerdings müssen, damit das innere Karussell **7b** beschickt bzw. entleert werden kann, die Lagerstellen **21** des äusseren Karussells **7a**, die mit der Schaufel **50** fluchten, mindestens dann leer sein, wenn man zum inneren Karussell **7b** Zugriff haben muss.

In den **Fig. 4a** und **4b** ist die Transporteinrichtung **9, 11** im einzelnen dargestellt, wobei **Fig. 4a** die Schaufel **50** in der Lage **12b** bzw. **12c** und **Fig. 4b** die Schaufel**50** in der Lage **12a** bzw. **12d** zeigt. Dargestellt sind ferner der Antrieb **18** für die lineare Vertikalverschiebung, der Drehantrieb **19** für die horizontale Verschwenkung um die Rotationsachse **14** und der Antrieb **17** für die lineare Horizontalbewegung, ferner eine Führungsvorrichtung **52** für die plattenförmige Schaufel **50**, auf welcher ein Objekt **8** angeordnet ist; dieses Objekt **8** ist stirnseitig mittels eines Rückhalters **55** und rückseitig mittels einem Führungskörper **56** geführt; weitere, nicht dargestellte Seitenführungen dienen dazu, das Objekt **8** auch seitlich zu führen. Die Horizontalverschiebeeinrichtung ist drehbar am Antrieb **18** befestigt.

**Fig. 4b** zeigt, wie schon erwähnt, die Schaufel **50** der Transporteinrichtung **11** in ausgefahrener Lage, in welcher sie Zugriff zum nicht dargestellten Zu- bzw. Abfuhr-Förderer oder zur Objekt-Lagervorrichtung **7** hätte. Der Antrieb der horizontalen Linearverschiebung der Schaufel **50,** die auch als Radialverschiebung bezeichnet werden kann, geschieht hierbei über einen Exzenterarm **57,** der einerseits über ein Verschiebelager **53** mit der Schaufel **50** und anderseits mit der Antriebsachse des Antriebs **17** verbunden ist.

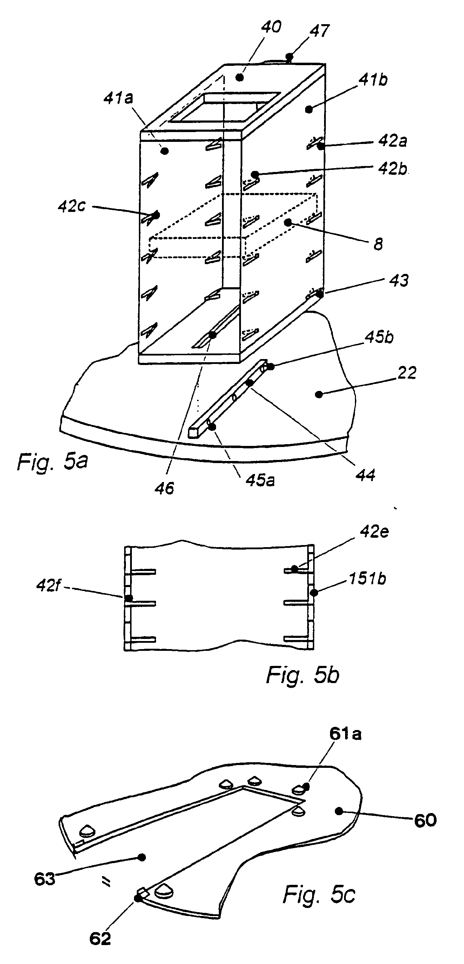

**Fig. 5a** zeigt ein erstes Ausführungsbeispiel einer Objekt-Lagervorrichtung, nämlich die schon früher erwähnte Kassette **15**. Sie weist einen Traggriff **40**, zwei Seitenwände **41a, 41b**, eine Bodenplatte **43** und einen Träger **47** auf. Die Seitenwände **41** weisen Stützelemente **42a, 42b, 42c, 42d** auf, von denen das letztere nicht sichtbar ist, und die Bodenplatte **43** besitzt eine Halte- bzw. Zentrierleiste **46**. Zur präzisen Positionierung der Kassette **15** sind auf dem Drehteller **22** Führungselemente **44** vorgesehen. Die Führungselemente umfassen Tangentialhalteelemente **45a** und Radialhalteelemente 45b. Die hier nicht dargestellten Objekte **8** liegen in der Kassette **15** so auf den Stützelementen **42a** bis **42d** auf, dass ihre nach unten gewandte Fläche für die Schaufel **50** der Transporteinrichtung **11** frei zugänglich ist. Die Stützelemente **42a** bis **42d** sind längs einer vertikal verlaufenden Biegelinie zur Innenfläche der Seitenwände **41a, 41b** eingebogen. Die Kassette **15** ist auf dem Drehteller **22** mittels der Zentrierleiste **46** bzw. des Führungselementes **44** gehalten. Die Zentrierleiste **46** liegt dabei zum einen in radialer und tangentialer Richtung und zum anderen über die Tangentialhalteelemente **45a** und die Radialhalrteelemente **45b** am Führungselement **44** an. Die Tangentilhalteelemente **45a** und die Radialhalteelemente **45b** können gefederte Druckstücke oder Haltemagnete sein.

Ein weiteres Beispiel von Stützelementen **42e, 42f** ist in **Fig. 5b** dargestellt. Dabei sind die Stützelemente **42e, 42f** als horizontale, rechtwinklig eingebogenen flanschartige Laschen ausgebildet.

**Fig. 5c** zeigt einen Ausschnitt einer Lagerstelle **23** für ein hier nicht dargestelltes Objekt. Bzw. einen entsprechenden Objektträger. Diese wird durch ein Tablar **60** gebildet, welches mit Führungs- bzw. Zentrierelementen **61a** und Halteelementen **62** bestückt ist. Eine Aussparung **63** im Tablar **60** ermöglicht den Zugriff der Schaufel **50**. Die Führungs- bzw. Zentrierelemente **61a** sind kegelförmig ausgebildet und kompensieren Positionierfehler beim Beschicken des Tablars **60** mit einem Objektträger, während die Halteelemente **52** ein Verrutschen der Objektträger **8** in radialer Richtung verhindern.

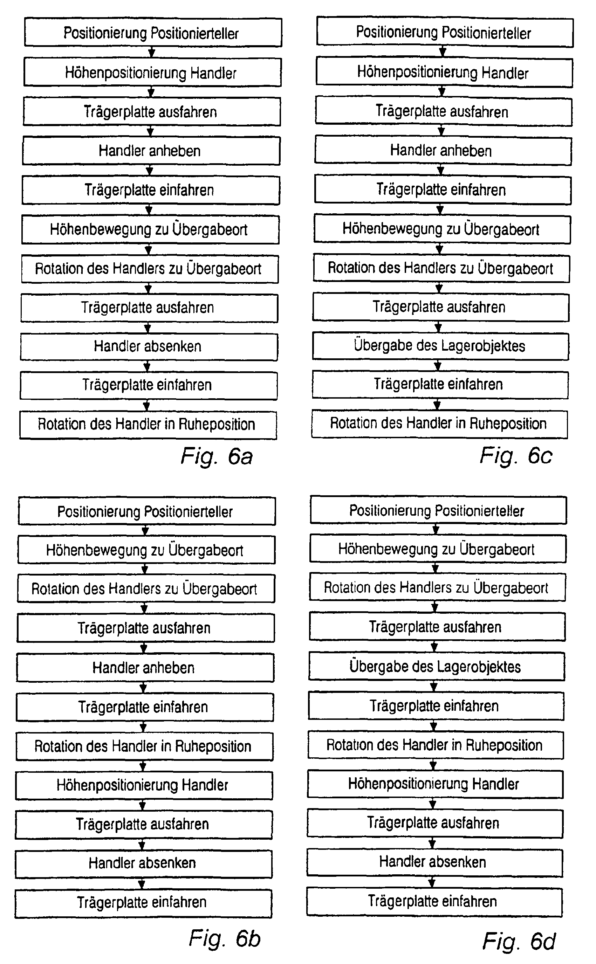

Der Vorgang der Entleerung bzw. Beschickung des Klimaschranks wird durch die Flussdiagramme **6a** bis **6d** beschrieben. Eine erste Variante des Entleerungsvorganges spielt sich gemäss **Fig. 6a** wie folgt ab: Im Ruhezustand befindet sich die Schaufel **50** in einer Lage gemäss **12b**. Bei der Entleerung des Klimaschrankes wird die Objekt-Lagervorrichtung **7** durch einen nicht dargestellten Antrieb in die gewünschte Winkellage gedreht, in welcher die zu leerende Lagerstelle **23** mit der Schaufel **50** fluchtet. Der Lift **10** der Transporteinrichtung **11** fährt der Löffel **50** so auf die gewünschte Etage, dass die Schaufel **50** unter den Objektträger bzw. das Objekt **8** gefahren werden kann, so dass es sich in der Lage gemäss **12a** befindet. Die Schaufel **50** wird nun soweit nach oben angehoben, dass der Objektträger bzw. das Objekt **8** nicht mehr auf der Lagerstelle **23** ruht sondern auf der Schaufel **50** abgestützt ist. Nunmehr wird die Schaufel **50** in eine Lage gemäss **12b** gebracht, und anschliessend verschiebt man die Schaufel **50** in diejenige Höhe, in der er sich bei der Verschiebung des Objektträgers durch das Fenster **6** befinden muss. Dann wird die Schaufel **50** um die Achse **14** geschwenkt, wodurch er in eine Lage gemäss **12c** gelangt. Daraufhin wird die Schaufel **50** horizontal durch das Fenster **6** geschoben, um in die Lage gemäss **12d** zu kommen. Die Schaufel **50** wird nun um ein weniges abgesenkt, damit das Objekt bzw. der Objektträger an den Förderer abgegeben werden kann, und anschliessend in die Lage gemäss **12c** zurückgezogen. Als letztes wird wieder die Ruhelage erreicht. Die Beschickung des Klimaschrankes spielt sich entsprechend gemäss **Fig. 6b** ab, während die **Fig. 6c** und **6d** eine zweite Variante des Entleerungs- bzw. Beschickungsvorganges darstellen und keiner weiteren Erläuterung bedürfen.

**Fig. 7** zeigt dasselbe Transfersystem **11**, welches weiter oben als in einem Klimaschrank angeordnet beschrieben wurde, jedoch ausserhalb eines Klimaschrankes, sowie eine Objekt-Lagervorrichtung in Form einer Kassette **15**, wie sie bereits beschrieben wurde. Es versteht sich von selbst, dass der gesamte Vorgang der Beschickung und Entleerung der Objekt-Lagervorrichtung bzw. Kassette **15** ausserhalb eines Klimaschrankes in gleicher Weise abläuft wie innerhalb eines Klimaschrankes, jedoch mit der Vereinfachung, dass das Fenster, durch welches das Objekt bzw. der Objektträger **8** geschoben werden muss und das gemäss obiger Beschreibung für die Objekte bzw. Objektträger **8** gewissermassen die Grenze zwischen dem Inneren und dem Äusseren des Klimaschrankes bildet, nicht vorhanden ist und daher auch nicht betätigt werden muss. Die Kassette **15** ist auch in diesem Fall auf einer Drehplatte **22** angeordnet.

## Patentansprüche

1. Lagerstation für Objekte, umfassend eine karussellartige Objekt-Lagervorrichtung (**7**) mit mindestens einer Lagerebene mit mehreren kreissektorförmigen Objekt-Lagerstellen (**23**), zur zeitweiligen Aufnahme einer Vielzahl von zu behandelnden, einzeln oder gruppenweise in Objektträgern (**8**) aufgenommenen Objekten, und eine Transporteinrichtung (**11**) zum Einbringen der Objektträger (**8**) in die Objekt-Lagervorrichtung (**7**) und zum Entfernen der Objektträger (**8**) aus der Objekt-Lagervorrichtung (**7**), **dadurch gekennzeichnet, dass** ein für die Aufnahme der Objektträger (**8**) vorgesehenes Element (**50**) der Transporteinrichtung (**11**) mittels einer Vertikalverschiebeeinrichtung parallel und mittels eines Horizontalantriebes (**17**) senkrecht zur Achse der karussellartigen Objekt-Lagervorrichtung (**7**) verschiebbar ist und dass das zur Aufnahme der Objektträger (**8**) vorgesehene Element (**50**) der Transporteinrichtung (**11**) horizontal um eine zur Achse der karussellartigen Objekt-Lagervorrichtung (**7**) parallele Schwenkachse zwischen einer ersten Übergabelage (**12c**), in der es auf eine Zu- bzw. Abfuhrfördereinrichtung gerichtet ist, und einer zweiten Übergabelage (**21b**), in der es auf eine Objekt-Lagerstelle (**23**) gerichtet ist, mittels eines Drehantriebes (**19**) schwenkbar ist.

2. Lagerstation nach Patentanspruch 1, **dadurch gekennzeichnet, dass** die Objekt-Lagervorrichtung (**7**) zur Aufnahme einer Vielzahl von zu behandelnden, einzeln oder gruppenweise in Objektträgern (**8**) aufgenommenen Objekten ausgebildet ist, mit einer karussellartigen Struktur, an der die Objektträger (**8**) in kreissektorförmigen Objekt-Lagerstellen (**23**) in einer oder mehreren Etagen angeordnet sind, wobei die Objektträger (**8**) nur mit einem Teil ihrer Unterfläche auf der Struktur aufliegen, während der restliche Teil ihrer Unterfläche von unten zugänglich ist, um die Objektträger (**8**) von der Struktur abzuheben.

3. Lagerstation nach mindestens einem der Patentansprüche 1 bis 2, **dadurch gekennzeichnet, dass** das zur Aufnahme der Objektträger (**8**) vorgesehene Element der Transporteinrichtung (**11**) als mindestens eine flache Schaufel (**50**) ausgebildet ist.

4. Lagerstation nach mindestens einem der Patentansprüche 1 bis 3, **dadurch gekennzeichnet, dass** die Objekt-Lagervorrichtung (**7**) und die Transporteinrichtung (**11**) in einem Klimaschrank (**1**) angeordnet sind.

5. Klimaschrank (**1**) mit einer Lagerstation nach einem der vorangehenden Ansprüche, welcher mindestens ein Fenster (**6**) mit einer Fensteröffnung aufweist, deren Abmessungen grössenmässig den Objektträgern (**8**) angepasst ist, wobei die Fensteröffnung ortsfest in einer Wandung des Klimaschrankes (**1**) angebracht und durch einen Fensterflügel dichtend verschliessbar ist, und wobei eine Transporteinrichtung (**11**) mit einem Horizontalantrieb (**17**), einem Vertikalantrieb (**18**) und einem Drehantrieb (**19**) im Klimaschrank (**1**) angeordnet ist, um die Objektträger (**8**) im Inneren des Klimaschrankes (**1**) zu verschieben.

6. Klimaschrank (**1**) nach Patentanspruch 5, **dadurch gekennzeichnet, dass** er eine Lagerstation mit der genannten Objekt-Lagervorrichtung (**7**) und einer Transporteinrichtung (**11**) zum Transportieren der Objektträger (**8**) im Inneren des Klimaschrankes (**1**) zwischen der Objekt-Lagervorrichtung (**7**) und der Nähe der Fensteröffnung des Klimaschrankes (**1**) enthält.

7. Klimaschrank (**1**) nach mindestens einem der Patentansprüche 5 bis 6, **dadurch gekennzeichnet, dass** die Objektträger (**8**) mittels der Transporteinrichtung (**11**) durch die Fensteröffnung des Fensters (**6**) transportierbar sind.

8. Klimaschrank (**1**) nach mindestens einem der Patentansprüche 5 bis 7, **dadurch gekennzeichnet, dass** er eine Türe (**5**) aufweist, die höher und breiter ist als das Fenster (**6**), um die Objekt-Lagervorrichtung (**7, 15**) ganz oder teilweise aus dem Klimaschrank (**1**) zu entfernen.

9. Klimaschrank (**1**) nach Patentanspruch 8, **dadurch gekennzeichnet, dass** die Türe dem Fenster (**6**) gegenüberliegt und daß sie manuell bedienbar ist.

## Claims

1. Storage station comprising a carousel-like object storage device (7) having at least one storage level with a plurality of object storage points (23) shaped like a sector of a circle for the temporary accommodation of a large number of objects to be treated accommodated singly or in groups in object carriers (8) and a transport device (11) for bringing the object carriers (8) into the object storage device (7) and for removing the object carriers (8) from the object storage device (7), **characterised in that** an element (50) of the transport device (11) provided for accommodating the object carriers (8) is displaceable by means of a vertical displacement device parallel to and by means of a horizontal drive (17) perpendicular to the axis of the carousel-like object storage device (7) and that the element (50) of the transport device (11) provided for accommodating the object carriers (8) is pivotable by means of a rotary drive (19) horizontally about a pivot axis parallel to the axis of the carousel-like object storage device (7) between a first transfer position (12c) in which it is directed at an infeed or withdrawal conveyor device and a second transfer position (21b) in which it is directed at an object storage point (23).

2. Storage station according to claim 1, **characterised in that** the object storage device (7) for accommodating a large number of objects to be treated accommodated singly or in groups in object carriers (8) is constructed with a carousel-like structure on which the object carriers (8) are arranged in one or more tiers in object storage points (23) shaped like a sector of a circle, wherein the object carriers (8) rest only by part of their lower surface on the structure while the remaining part of their lower surface is accessible from below in order to lift the object carriers (8) from the structure.

3. Storage station according to at least one of claims 1 to 2, **characterised in that** the element of the transport device (11) provided for accommodating the object carriers (8) is constructed in the form of at least one flat shovel (50).

4. Storage station according to at least one of claims 1 to 3, **characterised in that** the object storage device (7) and the transport device (11) are arranged in a conditioning cabinet (1).

5. Conditioning cabinet (1) having a storage station according to any of the preceding claims, which has at least one window (6) with a window opening whose dimensions are adapted in terms of size to the object carriers (8), wherein the window opening is fitted in fixed location in a wall of the conditioning cabinet (1) and is closable in sealing manner by a window casement and wherein a transport device (11) is arranged with a horizontal drive (17), a vertical drive (18) and a rotary drive (19) in the conditioning cabinet (1) in order to displace the object carriers (8) in the interior of the conditioning cabinet (1).

6. Conditioning cabinet (1) according to claim 5, **characterised in that** it contains a storage station having said object storage device (7) and a transport device (11) for transporting the object carriers (8) in the interior of the conditioning cabinet (1) between the object storage device (7) and the vicinity of the window opening of the conditioning cabinet (1).

7. Conditioning cabinet (1) according to at least one of claims 5 to 6, **characterised in that** the object carriers (8) are transportable by means of the transport device (11) through the window opening of the window (6).

8. Conditioning cabinet (1) according to at least one of claims 5 to 7, **characterised in that** it has a door (5) that is higher and wider than the window (6) in order to remove the object storage device (7, 15) in whole or in part from the conditioning cabinet (1).

9. Conditioning cabinet (1) according to claim 8, **characterised in that** the door is located opposite the window (6) and that it is manually operable.

## Revendications

1. Dispositif de stockage pour des objets, comprenant un dispositif de stockage d'objets (7) du genre carrousel, avec au moins un plan de stockage comprenant plusieurs points de stockage d'objets (23) en forme de secteur de cercle, pour recevoir par périodes une pluralité d'objets à traiter, logés individuellement ou par groupes dans des supports d'objets (8), et un dispositif de transport (11) pour introduire les supports d'objet (8) dans le dispositif de stockage d'objets (7) et pour enlever les supports d'objet (8) du dispositif de stockage d'objets (7), **caractérisé en ce qu'**un élément (50), prévu pour recevoir les supports d'objets (8), du dispositif de transport (11) est déplaçable, parallèlement à l'axe du dispositif de stockage d'objets (7) du genre carrousel, au moyen d'un dispositif de déplacement vertical, et perpendiculairement à l'axe du dispositif de stockage d'objets (7) du genre carrousel, au moyen d'un dispositif d'entraînement horizontal (17), et **en ce que** l'élément (50), prévu pour recevoir les supports d'objets (8), du dispositif de transport (11) est susceptible de pivoter horizontalement, au moyen d'un entraînement rotatif (19), autour d'un axe de pivotement parallèle à l'axe du dispositif support de stockage d'objets (7) du genre carrousel, entre une première position de transfert (12c), à laquelle il est orienté sur un dispositif de transport d'amenée et d'évacuation, et une deuxième position de transfert (21b), à laquelle il est orienté vers le point de stockage d'objets (23).

2. Dispositif de stockage selon la revendication 1, **caractérisé en ce que** le dispositif de stockage d'objets (7) est réalisé pour recevoir une pluralité d'objets à traiter, logés individuellement ou par groupes dans des supports d'objets (8), avec une structure du genre carrousel, sur laquelle les supports d'objets (8) sont disposés en un ou plusieurs étages en des points de stockage d'objets (23) en forme de secteur de cercle, les supports d'objets (8) ne reposant sur la structure que par une partie de leur face inférieure, tandis que la partie restante de leur face inférieure est accessible par le dessous, pour enlever les supports d'objets (8) de la structure.

3. Dispositif de stockage selon au moins l'une des revendications 1 à 2, **caractérisé en ce que** l'élément, prévu pour recevoir les supports d'objets (8), du dispositif de transport (11) est réalisé sous la forme d'au moins une pale (50) plate.

4. Dispositif de stockage selon au moins l'une des revendications 1 à 3, **caractérisé en ce que** le dispositif de stockage d'objets (7) et le dispositif de transport (11) sont disposés dans une armoire de climatisation (1).

5. Armoire de climatisation (1) avec un dispositif de stockage selon l'une des revendications précédentes, présentant au moins une fenêtre (6) avec une ouverture de fenêtre, dont les dimensions sont adaptées en tailles aux supports d'objets (8), l'ouverture de fenêtre étant ménagée, de façon localement fixe, dans une paroi de l'armoire de climatisation (1) et pouvant être fermée, de façon étanche, au moyen d'un battant de fenêtre, et où un dispositif de transport (11) est disposé, avec un dispositif d'entraînement horizontal (17), un dispositif d'entraînement vertical (18) et un dispositif d'entraînement rotatif (19), dans l'armoire de climatisation (1), pour déplacer les supports d'objets (8) à l'intérieur de l'armoire de climatisation (1).

6. Armoire de climatisation (1) selon la revendication 5, **caractérisée en ce que** qu'elle contient un poste de stockage avec le dispositif de stockage d'objets (7) cité et un dispositif de transport (11) pour transporter les supports d'objets (8) à l'intérieur de l'armoire de climatisation (1), entre le dispositif de stockage d'objets (7) et la proximité de l'ouverture de fenêtre de l'armoire de climatisation (1).

7. Armoire de climatisation (1) selon au moins l'une des revendications 5 à 6, **caractérisée en ce que** les supports d'objets (8) sont susceptibles d'être transportés à travers l'ouverture de la fenêtre (6), au moyen du dispositif de transport (11).

8. Armoire de climatisation (1) selon au moins l'une des revendications 5 à 7, **caractérisée en ce qu'**elle présente une porte (5) plus haute et plus large que la fenêtre (6), pour enlever le dispositif de stockage d'objets (7, 15), en totalité ou en partie, de l'armoire de climatisation (1).

9. Armoire de climatisation (1) selon la revendication 8, **caractérisée en ce que** la porte est placée à l'opposé de la fenêtre (6) et peut être manoeuvrée manuellement.
